# FASCICULE DE BREVET EUROPEEN

(11) **EP 3 401 914 B1**
(45) Date de publication et mention de la délivrance du brevet: **25.11.2020**
(21) Numéro de dépôt: 18170975.9
(22) Date de dépôt: 07.05.2018
(51) Int. Cl.: G11C 13/00, G11C 29/02

(54) **PROCEDE DE GESTION DE L'ENDURANCE D'UNE MEMOIRE REINSCRIPTIBLE NON VOLATILE ET DISPOSITIF DE PROGRAMMATION D'UNE TELLE MEMOIRE**
VERFAHREN ZUR STEUERUNG DER LEBENSDAUER EINES NICHT-FLÜCHTIGEN ÜBERSCHREIBBAREN SPEICHERS, UND PROGRAMMIERUNGSVORRICHTUNG EINES SOLCHEN SPEICHERS
METHOD FOR MANAGING THE ENDURANCE OF A NON-VOLATILE REWRITABLE MEMORY AND DEVICE FOR PROGRAMMING SUCH A MEMORY

(30) Priorité: 09.05.2017 FR 1754044
(43) Date de publication de la demande: 14.11.2018
(73) Titulaire: Commissariat à l'Energie Atomique et aux Energies Alternatives, 75015 Paris (FR)
(72) Inventeur: MOLAS, Gabriel, 38000 GRENOBLE (FR); HARRAND, Michel, 38120 SAINT-EGREVE (FR); VIANELLO, Elisa, 38000 GRENOBLE (FR)
(74) Mandataire: Cabinet Camus Lebkiri

(56) Documents cités:
- WO-A2-2011/103379
- US-A1- 2011 205 782
- US-A1- 2013 058 153
- US-A1- 2013 198 436
- US-A1- 2014 328 108
- US-A1- 2015 243 353
- US-B1- 9 047 948

## Description

### DOMAINE TECHNIQUE

La présente invention concerne un procédé de gestion de l'endurance d'une mémoire réinscriptible non volatile. L'invention concerne également un dispositif de programmation d'une telle mémoire réinscriptible non volatile.

L'invention trouve des applications dans le domaine des mémoires réinscriptibles non volatiles et, plus spécifiquement, celui des mémoires résistives de type OxRRAM (« Oxyde-based Resistive RAM ») et CBRAM (« Conductive Bridging RAM »).

### ETAT DE LA TECHNIQUE

Dans le domaine des mémoires réinscriptibles non volatiles, différents types de mémoires sont utilisés en fonction des applications et des performances visées. Les mémoires les plus couramment utilisées, en particulier dans les appareils photos numériques, les téléphones cellulaires, les ordinateurs portables, le clés USB, et autres dispositifs portables, sont des mémoires appelées « mémoires Flash ». Les mémoires flash offrent, notamment, une forte densité d'intégration, une grande résistance aux chocs et une bonne durabilité.

La plupart des mémoires Flash non-volatiles du commerce utilisent le stockage de charges comme principe de codage de l'information. En pratique, une couche de piégeage de charge (généralement du polysilicium, ou un diélectrique comme le SiN) est encapsulée entre deux diélectriques dans l'empilement de grille d'un transistor MOS. La présence ou l'absence de charge dans ce medium modifie la conduction du transistor MOS et permet de coder l'état de la mémoire.

Toutefois, l'évolution de la microélectronique nécessite une miniaturisation toujours plus poussée des composants et, en particulier, des mémoires réinscriptibles non volatiles. Or, la miniaturisation de la technologie Flash est limitée, notamment par le fait que l'épaisseur de la couche de piégeage de charge ne peut être réduite en dessous d'une valeur minimale (de l'ordre de 6nm) sous peine de diminuer le temps de rétention de l'information.

Récemment, un nouveau type de mémoires, appelées mémoires résistives, ont fait leur apparition pour remplacer les mémoires Flash. Ces mémoires résistives ne reposent pas sur le piégeage de charge des grilles de transistors, mais sur un changement d'état d'un bloc résistif. Les mémoires résistives, notamment les mémoires résistives à base d'oxyde, nommées OxRRAM, et les mémoires résistives à base de matériau à conduction ionique, nommées CBRAM, sont basées sur un changement de l'état de résistance (forte ou faible résistance) d'un matériau actif intégré entre deux électrodes métalliques. Ce nouveau type de mémoire permet, non seulement une forte densité d'intégration, mais également une vitesse de fonctionnement élevée, une grande endurance et une bonne compatibilité avec les procédés de fabrication utilisés actuellement dans l'industrie microélectronique, en particulier avec les procédés de fin de ligne de la technologie CMOS.

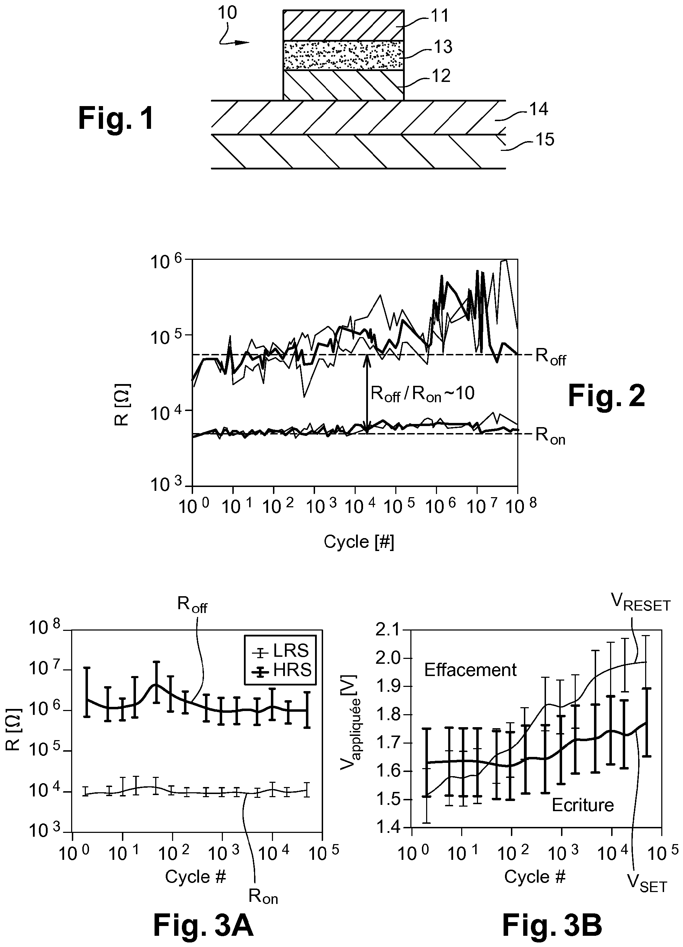

Une mémoire résistive comprend généralement une pluralité de cellules mémoire, appelées également points mémoire. Chaque cellule mémoire comporte un empilement 10 d'une première et d'une seconde électrodes, généralement en métal, et d'une couche en matériau actif, par exemple un oxyde de métal, disposé entre les deux électrodes. Un exemple d'une cellule mémoire résistive est représenté sur la figure 1. Cette mémoire résistive comporte une première électrode 11, une seconde électrode 12 et une couche en matériau diélectrique 13 agencée entre les première et seconde électrodes. La seconde électrode 12 de la mémoire résistive est ménagée au contact d'un substrat connecteur 14 assurant un contact électrique entre un dispositif de programmation et l'empilement. Le dispositif de programmation permet de contrôler les conditions de programmation, par exemple la tension de programmation, appliquées aux électrodes 11 et 12 de l'empilement.

La couche en matériau diélectrique13, appelée également couche active, est apte à commuter, de manière réversible, entre deux états de résistance qui correspondent aux valeurs logiques « 0 » et « 1 » utilisées pour coder un bit d'information. Ainsi, un empilement de mémoire résistive peut basculer d'un état faiblement résistif LRS (« Low Résistance State » en termes anglo-saxons) à un état fortement résistif HRS (« High Résistance State » en termes anglo-saxons) par l'application d'une première tension VRESET entre la première 11 et la seconde 12 électrodes, et rebasculer de l'état fortement résistif HRS à l'état faiblement résistif LRS par l'application d'une deuxième tension VSET entre les première et seconde électrodes. En particulier, une information est écrite dans la cellule mémoire en basculant la couche en matériau diélectrique de l'état fortement résistif HRS, appelé également état « OFF », à l'état faiblement résistif LRS, ou état « ON ». À l'inverse, une information peut être effacée de la cellule mémoire en basculant la couche en matériau diélectrique de l'état LRS vers l'état HRS. L'opération d'écriture dans la cellule mémoire est appelée « SET » ; l'opération d'effacement de ladite cellule mémoire est appelée « RESET ».

Ainsi, lors d'une opération d'écriture, le matériau diélectrique comporte une première valeur de résistance et, lors d'une opération d'effacement, il comporte une deuxième valeur de résistance, inférieure à la première valeur de résistance. Le changement de résistance du matériau diélectrique est gouverné par la formation et la rupture d'un filament conducteur de section nanométrique entre les deux électrodes 11-12. En l'état actuel des connaissances, ce filament semble être dû à des phénomènes différents, dépendant du type de matériau utilisé pour la couche de matériau actif. En particulier, dans une mémoire résistive de type OxRRAM dans laquelle la couche de matériau diélectrique est à base d'oxyde, le changement d'état résistif semble s'expliquer par la formation d'un filament de lacunes d'oxygène au sein de ladite couche de matériau diélectrique. Dans une mémoire résistive de type CBRAM, dans laquelle la couche de matériau diélectrique comporte un matériau à conduction ionique formant un électrolyte solide à conduction ionique disposé entre une électrode formant une cathode inerte et une électrode comportant une portion de métal ionisable, le changement d'état résistif semble s'expliquer par la formation d'un filament conducteur au sein de la couche de matériau diélectrique.

Divers documents décrivent des mémoires résistives. Par exemple, le document US 2013/0058153 A1 divulgue un procédé de fonctionnement d'une mémoire résistive et le document US 2015/243353 A1 divulgue une méthode pour programmer une mémoire résistive.

Toutefois, dans les mémoires résistives, il existe une certaine variabilité des niveaux de résistances, tant à l'état faiblement résistif LRS qu'à l'état fortement résistif HRS. En effet, à chaque cycle d'écriture et d'effacement de la mémoire, les valeurs de la résistance Roff à l'état fortement résistif HRS et les valeurs de la résistance Ron à l'état faiblement résistif LRS fluctuent, comme représenté par les courbes de fluctuation des résistances Roff et Ron de la figure 2.

En outre, au fur et à mesure des cycles d'écriture et d'effacement de la mémoire, les niveaux des résistances du matériau diélectrique dérivent, s'écartant de plus en plus des valeurs de résistance des premiers cycles, comme montré par la figure 2. Du fait de ces dérives, les conditions de programmation - par exemple la tension ou le courant de programmation - doivent être modifiées pour permettre l'écriture ou l'effacement d'un matériau diélectrique. Ces modifications consistent généralement à appliquer une tension ou un courant de programmation très fort ou, au contraire, très faible. Or, l'application de conditions de programmation trop faibles empêche toute écriture et l'application de conditions de programmation trop fortes lors de l'opération d'effacement génère des défauts dans le matériau diélectrique, ce qui dégrade le matériau diélectrique. Les performances des mémoires résistives ont donc tendance à se dégrader de plus en plus au fil des cycles d'écriture et d'effacement. Les performances en endurance de ces mémoires sont donc relativement restreintes.

Pour remédier à ce problème d'endurance et ainsi allonger la durée de vie des mémoires résistives, il est connu d'utiliser un procédé dit de « smart programming » qui a pour objectif de compenser les défauts accumulés au cours de plusieurs cycles d'écriture et d'effacement de la mémoire. Pour cela, le procédé de smart programming propose d'appliquer une tension de compensation qui augmente progressivement jusqu'à ce que le matériau diélectrique atteigne une valeur de résistance cible. Autrement dit, ce procédé propose de déterminer une valeur de résistance cible considérée comme la valeur de résistance optimale à atteindre. Une tension de compensation - ou une durée ou un nombre d'impulsions à niveau de tension constant - destinée à compenser les défauts dans le matériau diélectrique, est ensuite appliquée depuis une valeur faible qui est augmentée pas par pas jusqu'à ce que la résistance atteigne la valeur cible prédéterminée. Les conditions de compensation (tension ou durée d'impulsion) sont appliquées pour compenser les défauts au sein du matériau diélectrique aussi bien dans son état faiblement résistif que dans son état fortement résistif.

Les figures 3A et 3B représentent des courbes, respectivement, des valeurs de résistances du matériau diélectrique et des valeurs de la tension de compensation appliquée à la mémoire, au cours des cycles, lorsqu'un procédé de smart programming est utilisé. Comme le montrent ces courbes, lorsqu'une tension de compensation en écriture (courbe « set ») et en effacement (courbe « reset ») est appliquée, la valeur de la résistance augmente. Cependant, l'augmentation des valeurs de résistance n'est que momentanée, les valeurs de résistances diminuant à nouveau rapidement après l'application de la tension de compensation. En effet, la compensation en tension n'étant réalisée qu'après un certain nombre de cycles - par exemple aux environs de 10² et 10⁴ cycles sur les figures 3A-3B - la mémoire est déjà fortement détériorée lorsque la tension de compensation est appliquée. Cette compensation camouffle donc les défauts générés au fur et à mesure des cycles, sans toutefois les réparer. En effet, les défauts du matériau diélectrique à l'origine de la modification des niveaux résistifs du matériau diélectriques sont irréversibles. Il n'est donc pas possible de les réparer, mais uniquement de les compenser.

Or, la compensation de ces défauts avec le procédé de smart programming nécessite l'application de fortes conditions de compensation, par exemple une tension de compensation élevée. Or, de fortes conditions de compensation génèrent de nouveaux défauts au sein du matériau diélectrique ; et plus les conditions de compensation sont élevées, plus le nombre de défauts est élevé.

Pour compenser les défauts le plus justement possible, il pourrait être envisagé d'augmenter le niveau des conditions de compensation très lentement, avec un pas très court, jusqu' à d'atteindre le niveau juste suffisant pour compenser les défauts, sans générer trop de défauts supplémentaires. Toutefois, une telle pratique serait si longue qu'elle ne serait pas exploitable industriellement.

### RESUME DE L'INVENTION

L'invention est définie par l'objet des revendications 1 et 6. D'autres modes de réalisation préférés sont définis dans les revendications dépendantes. Pour répondre au problème évoqué ci-dessus de la compensation momentanée des défauts dans le matériau diélectrique, le demandeur propose un procédé de gestion de l'endurance d'une mémoire résistive dans lequel des conditions de programmation sont déterminées à la fin de chaque opération d'écriture ou d'effacement afin de limiter les dérives de résistance à chaque opération et, ainsi, ralentir la dégradation de la mémoire.

Selon un premier aspect, l'invention concerne un procédé de gestion de l'endurance d'une mémoire réinscriptible non-volatile comprenant une pluralité d'empilements ordonnés d'une électrode inférieure, d'une couche de matériau diélectrique et d'une électrode supérieure, le matériau diélectrique de chaque empilement étant apte à commuter entre :
- un état fortement résistif, dans lequel ledit matériau diélectrique présente une première valeur de résistance (Roff), et
- un état faiblement résistif, dans lequel ledit matériau diélectrique présente une deuxième valeur de résistance (Ron),
une commutation entre l'état fortement résistif et l'état faiblement résistif autorisant une écriture dans la mémoire et une commutation entre l'état faiblement résistif et l'état fortement résistif autorisant un effacement dans ladite mémoire.

Le fait de limiter les défauts dans le matériau diélectrique, à chaque opération d'écriture ou d'effacement, permet de stabiliser les dérives de résistance de chaque cellule mémoire d'une mémoire résistive. Cette stabilité des dérives de résistance augmente l'endurance de la mémoire et donc sa durée de vie.

L'utilisation des lois de dépendance permet d'adapter le procédé de l'invention à tous types de mémoires résistives, chaque type de mémoire résistive ayant ses propres lois de dépendance.

Dans la description qui suit, l'expression « opération d'écriture » définit une étape d'écriture d'une donnée dans une cellule mémoire et l'expression « opération d'effacement » définit une étape d'effacement de cette même donnée. Une opération d'écriture suivie d'une opération d'effacement constitue un cycle d'écriture et d'effacement, appelé plus simplement cycle.

Ainsi, l'expression « conditions de programmation » est à interpréter comme des conditions pour écrire dans une cellule mémoire et/ou effacer cette cellule mémoire. Les conditions de programmation peuvent donc être des conditions en écriture ou des conditions en effacement d'une cellule mémoire. Les conditions de programmation en écriture sont déterminées en fonction d'une opération d'effacement terminée, appelée opération d'effacement précédente, dans le but d'être appliquées à l'opération d'écriture suivante. De façon similaire, les conditions de programmation en effacement sont déterminées en fonction d'une opération d'écriture terminée, appelée opération d'écriture précédente, dans le but d'être appliquées à l'opération d'effacement suivante.

Selon certaines variantes, seules les opérations d'écriture ou seules les opérations d'effacement peuvent être réalisées avec les conditions de programmation déterminées de la façon définie ci-dessus. Selon d'autres variantes, à la fois les opérations d'écriture et les opérations d'effacement sont réalisées avec les conditions de programmation déterminées de la façon définie ci-dessus.

Selon une variante, les conditions de programmation comprennent une tension de programmation appliquée entre les électrodes de chaque empilement pendant une durée constante.

Selon une autre variante, les conditions de programmation comprennent une durée d'application d'une tension entre les électrodes de chaque empilement, ladite tension étant constante.

Avantageusement, chaque loi de dépendance est calibrée préalablement à toutes opérations d'écriture et d'effacement. Elles peuvent être calibrées par mesures ou par calculs à partir de paramètres spécifiques à chaque type de mémoire résistive.

Selon certains modes de réalisation, les conditions de programmation lues sont mémorisées au moins partiellement jusqu'aux opérations d'écriture ou d'effacement suivantes, dans au moins une cellule mémoire de la mémoire.

Selon un second aspect, l'invention concerne un dispositif de programmation d'une mémoire réinscriptible non-volatile comportant un circuit de programmation connecté aux électrodes de chaque empilement de la mémoire. Ce dispositif se caractérise par le fait qu'il met en œuvre le procédé définit ci-dessus.

Selon certains modes de réalisation, le circuit de programmation comporte une pluralité de générateurs de tension aptes à générer chacun au moins une valeur de tension de programmation.

Selon d'autres modes de réalisation, le circuit de programmation comporte au moins un générateur de tension connecté à des ponts diviseurs.

Ces différents modes de réalisation permettent de faire varier la tension de programmation afin que la tension appliquée aux électrodes soit le plus proche possible de la valeur de tension déterminée.

Selon encore d'autres modes de réalisation, le circuit de programmation comporte au moins un générateur de tension connecté à au moins un compteur et/ou une horloge apte à moduler une durée d'application d'une tension constante sur les électrodes.

Ces modes de réalisation permettent de faire varier les conditions de programmation avec un circuit simple et peu couteux.

### BREVE DESCRIPTION DES FIGURES

D'autres avantages et caractéristiques de l'invention apparaîtront à la lecture de la description, illustrée par les figures dans lesquelles :
- La figure 1, déjà décrite, représente schématiquement un exemple d'une cellule mémoire d'une mémoire résistive ;
- La figure 2, déjà décrite, représente des exemples d'évolution des résistances Roff et Ron d'une cellule mémoire au cours des cycles ;
- Les figures 3A et 3B, déjà décrites, représentent des exemples d'évolution des résistances Roff et Ron, en fonction des tensions d'écriture et d'effacement, lors d'une mise en œuvre du procédé de smart programming ;
- Les figures 4A et 4B représentent des exemples d'évolution et de distribution des résistances Roff et Ron, lors d'une mise en œuvre du procédé selon l'invention ;
- Les figures 5A-5C représentent des exemples de lois de dépendance utilisées dans le procédé selon l'invention ;
- La figure 6 représente un exemple d'une loi reliant la durée d'application d'une tension avec la valeur de la tension ;
- Les figures 7A et 7B représentent schématiquement deux modes de mise en œuvre de l'ajustement des conditions de programmation.

### DESCRIPTION DETAILLEE D'AU MOINS UN MODE DE REALISATION

Un exemple d'un procédé de gestion de l'endurance d'une mémoire résistive est décrit en détail ci-après, en référence aux dessins annexés. Cet exemple illustre les caractéristiques et avantages de l'invention. Il est toutefois rappelé que l'invention ne se limite pas à cet exemple.

Sur les figures, les éléments identiques sont repérés par des références identiques. Pour des questions de lisibilité des figures, les échelles de taille entre éléments représentés ne sont pas respectées.

Le procédé de gestion de l'endurance selon l'invention est mis en œuvre dans une mémoire résistive comportant une pluralité de cellules mémoires, du type de celui représenté sur la figure 1 décrite précédemment. Chaque cellule mémoire comporte un empilement 10, formé d'une électrode inférieure 12, d'une électrode supérieure 11 et d'une couche de matériau diélectrique 13 et associé à un circuit de programmation 15 apte à appliquer une différence de potentiel entre les deux électrodes 11 et 12. Plusieurs cellules mémoire sont agencées les unes à côté des autres, sur un ou plusieurs étages pour former une mémoire résistive.

La couche de matériau diélectrique 13, par exemple une couche en Oxyde de Hafnium (HfO₂), est capable de passer d'un état faiblement résistif LRS à un état fortement résistif HRS, et inversement, sous l'effet d'une tension appliquée entre les électrodes supérieure et inférieure. A l'état faiblement résistif, le matériau diélectrique a une résistance d'une valeur Ron ; à l'état fortement résistif, le matériau diélectrique a une résistance d'une valeur Roff, supérieure à Ron. Une commutation du matériau diélectrique de l'état fortement résistif HRS à l'état faiblement résistif LRS permet d'écrire une donnée ; une commutation du matériau diélectrique de l'état faiblement résistif LRS à l'état fortement résistif HRS permet d'effacer la donnée.

Le procédé de l'invention propose de limiter les dérives des résistances Roff et Ron à chaque cycle, c'est-à-dire à chaque opération d'écriture et à chaque opération d'effacement, de façon à diminuer, voir empêcher, la formation de défauts dans le matériau diélectrique 13. Pour cela, le procédé de l'invention propose de déterminer les conditions de programmation en fonction de valeurs de résistance médianes. En particulier, le procédé propose de déterminer les conditions de programmation de sorte que, à l'état fortement résistif HRS, la résistance Roff du matériau diélectrique fluctue autour d'une première valeur de résistance médiane Roffmed et que, à l'état faiblement résistif LRS, la résistance Ron du matériau diélectrique fluctue autour d'une deuxième valeur de résistance médiane Ronmed.

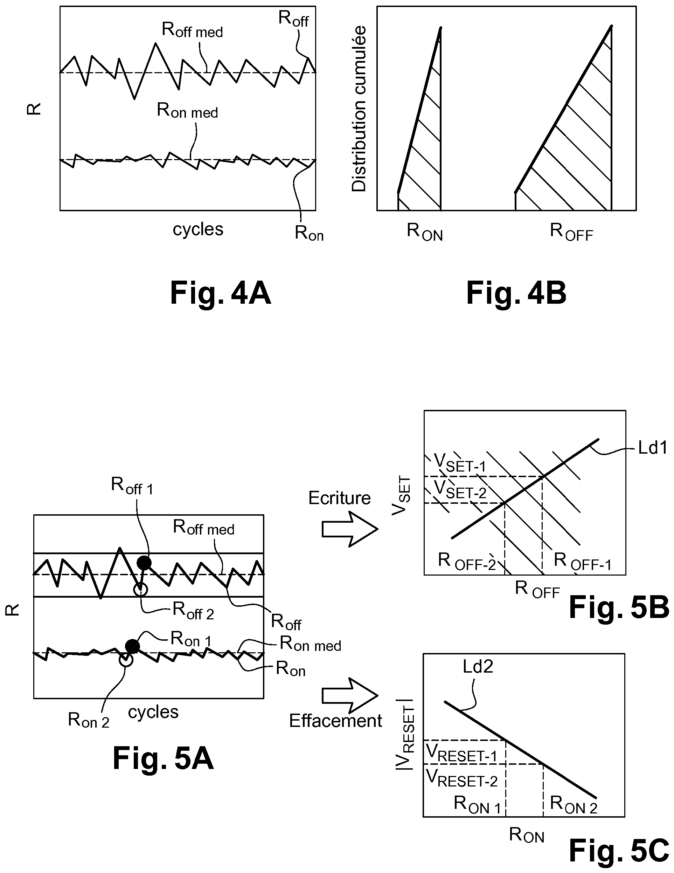

Les figures 4A et 4B représentent, respectivement, des exemples de fluctuation des résistances Roff et Ron, d'une même cellule mémoire, sur plusieurs cycles, et la distribution cumulée des valeurs des résistances Roff et Ron d'une cellule mémoire. Plus précisément, la figure 4A représente la courbe des valeurs de résistance Roff qui fluctuent autour de la première valeur de résistance médiane Roffmed et la courbe des valeurs de résistance Ron qui fluctuent autour de la deuxième valeur de résistance médiane Ronmed. Le filament au sein du matériau diélectrique ayant une forme variable à la fin de chaque opération d'écriture et d'effacement, la résistance dudit matériau diélectrique, qui dépend de la fluctuation du filament, a des valeurs stochastiques, aussi bien à l'état fortement résistif qu'à l'état faiblement résistif. Le procédé de l'invention propose d'ajuster les conditions de programmation de chaque cellule mémoire en fonction de la valeur de résistance du matériau diélectrique à la fin de chaque opération d'écriture et d'effacement de sorte à compenser, à chaque opération, les fluctuations dudit filament. Ainsi, le fait de déterminer, à chaque opération, les conditions de programmation à utiliser à l'opération suivante permet d'écrire et d'effacer les données avec des conditions optimales qui limitent la génération de défauts dans la cellule mémoire. L'état du matériau diélectrique et de ses défauts sont donc compensés à chaque opération d'écriture et d'effacement, avant que la mémoire n'ait trop dérivé. En effet, le fait de compenser une dérive de la résistance Roff ou Ron rapidement après la naissance de ladite dérive permet de stabiliser l'état, respectivement, fortement ou faiblement résistif du matériau diélectrique.

Selon certains modes de réalisation, les conditions de programmation peuvent être la tension de programmation, c'est-à-dire la différence de potentiel appliquée entre les deux électrodes d'un empilement, qui permet d'écrire ou d'effacer une donnée sur/de la cellule mémoire en assurant une valeur de résistance du matériau diélectrique proche de la valeur de résistance médiane. Dans un tel mode de réalisation, la tension appliquée entre les électrodes est variable et la durée d'application de cette tension est constante. Au contraire, les conditions de programmation peuvent être la durée d'application de la tension aux électrodes, ce qui correspond également au nombre d'impulsions appliquées aux électrodes. Dans ce cas, la durée ou le nombre d'impulsions est variable et la différence de potentiel est constante. En effet, l'homme du métier comprendra que du fait de l'équivalence, connue dans le domaine des mémoires résistives, entre le niveau de tension et la durée de la mise sous tension, il est possible d'appliquer aux électrodes, indifféremment, soit une tension de valeur constante avec une durée ou un nombre d'impulsions variable, soit une tension de valeur variable mais avec une durée ou un nombre d'impulsions constant.

Dans les exemples qui vont maintenant être décrits, les conditions de programmation variables seront la tension appliquée entre les électrodes d'une cellule mémoire, étant entendu que des exemples similaires pourraient être décrits où la durée d'application ou le nombre d'impulsions serait variable plutôt que la tension.

Les figures 5A-5C représentent des exemples de courbes permettant la détermination de tensions de programmation avec le procédé selon l'invention. En particulier, la figure 5A montre un exemple d'une valeur de résistance Roff1 et d'une valeur de résistance Roff2, respectivement, supérieure et inférieure à la valeur de résistance médiane Roffmed ainsi qu'un exemple d'une valeur de résistance Ron1 et d'une valeur de résistance Ron2, respectivement, supérieure et inférieure à la valeur de résistance médiane Ronmed. Comme représenté sur la figure 5A, les valeurs de résistance médiane Ronmed et Roffmed suivent une loi linéaire et les valeurs de résistance Ron et Roff, lues à la fin d'une opération d'écriture et/ou d'effacement, sont comparées aux valeurs médianes respectives Ronmed et Roffmed. Le résultat de cette comparaison permet de déterminer les conditions de programmation au cours des opérations d'effacement et/ou d'écriture suivantes.

Les figures B et C représentent des valeurs de résistance médiane Ronmed et Roffmed qui suivent, respectivement, une première et une deuxième lois de dépendance référencées Ld1, Ld2. En particulier, la figure 5B montre les tensions de programmation en écriture Vset1 et Vset2 correspondant, d'après la loi de dépendance Ld1, aux valeurs de résistance Roff1 et Roff2. La figure 5C montre les tensions de programmation en effacement Vreset1 et Vreset2 correspondant, d'après la loi de dépendance Ld2, aux valeurs de résistance Ron1 et Ron2.

Dans cet exemple, si la valeur de résistance à l'état HRS, lue à la fin d'une opération d'effacement, est Roff1, alors la tension de programmation en écriture au cours de l'opération d'écriture suivante sera Vset1. De même, si la valeur de résistance à l'état HRS, lue à la fin d'une opération d'effacement, est Roff2, alors la tension de programmation en écriture au cours de l'opération d'écriture suivante sera Vset2.

De façon similaire, si la valeur de résistance à l'état LRS, lue à la fin d'une opération d'écriture, est Ron2, alors la tension de programmation en effacement au cours de l'opération d'effacement suivante sera Vreset2. Et si la valeur de résistance à l'état LRS, lue à la fin d'une opération d'écriture, est Ron1, alors la tension de programmation en effacement au cours de l'opération d'effacement suivante sera Vreset1. Ainsi, plus la donnée a été effacée avec une résistance de valeur élevée, plus la donnée suivante sera écrite dans la cellule mémoire avec une valeur de tension d'écriture élevée. Les conditions de programmation sont donc déterminées, avant chaque opération d'écriture et/ou d'effacement, en fonction des valeurs de résistances lues au cours des opérations d'écriture et/ou d'effacement précédentes, en tenant compte de l'évolution stochastique de la valeur de résistance du matériau diélectrique.

Dans un mode de réalisation, dont un exemple est représenté sur la figure 5B, les tensions de programmation peuvent être comprises dans une fenêtre de tension de programmation, comme la fenêtre de tension de programmation en écriture définie entre Vset1 et Vset2. Une telle fenêtre de tension de programmation présente l'avantage d'empêcher l'application d'une tension trop élevée, ce qui limite la génération des défauts dans chaque cellule mémoire.

Le fait d'appliquer, à chaque opération d'écriture et/ou d'effacement, une tension de programmation adaptée à la résistance du matériau diélectrique lors de l'opération d'écriture et/ou d'effacement précédente permet de limiter la génération de défauts dans ledit matériau. Le fait de limiter les défauts permet de ralentir la dégradation de la mémoire et ainsi d'améliorer son endurance et donc sa durée de vie.

Les lois de dépendance Ld1 et Ld2 entre la tension de programmation et les valeurs de résistance sont des lois prédéterminées lors d'une étape de calibration préliminaire. Ces lois diffèrent selon la technologie de la mémoire. Par exemple, une mémoire résistive de type OxRRAM avec une couche d'Oxyde de Hafnium comme matériau diélectrique présentera des lois de dépendance différentes de celles d'une mémoire CBRAM avec une couche de Sulfure de Germanium.

Ces lois de dépendance peuvent être déterminées par calculs, par exemple, par simulation en utilisant des modèles de RRAM. Ces lois de dépendance Ld1 et Ld2 peuvent également être déterminées expérimentalement, par des mesures successives Par exemple, la loi de dépendance Ld1 relative à la tension d'écriture en fonction des valeurs de résistance Roff de l'état fortement résistif peut être construite de la façon suivante : en considérant plusieurs cellules mémoire avec des valeurs initiales différentes de résistance Roff, on applique successivement plusieurs impulsions d'écriture (avec une durée d'impulsion constante) en augmentant la tension d'écriture à chaque impulsion. La tension à partir de laquelle la cellule mémoire est écrite (donc lorsque l'état fortement résistif commute à l'état faiblement résistif) est définie comme la tension d'écriture (Vset). Le fait d'appliquer cette technique à plusieurs valeurs de résistance Roff initiales permet de construire la courbe représentative de la loi de dépendance Ld1, pour une durée d'impulsion donnée.

De façon similaire, la loi de dépendance Ld2 relative à la tension d'effacement en fonction des valeurs de résistance Ron de l'état faiblement résistif peut être construite de la façon suivante : en considérant plusieurs cellules mémoire avec des valeurs initiales différentes de résistance Ron, on applique successivement plusieurs impulsions d'effacement (avec une durée d'impulsion constante) en augmentant la tension d'effacement à chaque impulsion. La tension à partir de laquelle la cellule mémoire est effacée (donc lorsque l'état faiblement résistif commute à l'état fortement résistif) est définie comme la tension d'effacement (Vreset). Le fait d'appliquer cette technique à plusieurs valeurs de résistance Ron initiales permet de construire la courbe représentative de la loi de dépendance Ld2, pour une durée d'impulsion donnée.

Selon d'autres modes de réalisation, la loi de dépendance relie la durée d'application (ou le nombre d'impulsions) à tension constante, avec la valeur de résistance. Par exemple, dans le cas d'une détermination par mesures successives, la loi de dépendance Ld1 relative à la durée d'impulsion d'écriture en fonction des valeurs de résistance Roff de l'état fortement résistif peut être construite de la façon suivante : en considérant plusieurs cellules mémoire avec des valeurs initiales différentes de résistance Roff, on applique successivement plusieurs impulsions d'écriture (avec une valeur de tension constante) en augmentant le temps d'écriture à chaque impulsion. La durée d'impulsion à partir de laquelle la cellule mémoire est écrite (donc lorsque l'état fortement résistif commute à l'état faiblement résistif) est définie comme le temps d'écriture (Tset). Le fait d'appliquer cette technique à plusieurs valeurs de résistance Roff initiales permet de construire la courbe représentative de la loi de dépendance Ld1, pour une valeur de tension donnée.

De façon similaire, la loi de dépendance Ld2 relative à la durée d'impulsion d'effacement en fonction des valeurs de résistance Ron de l'état faiblement résistif peut être construite de la façon suivante : en considérant plusieurs cellules mémoire avec des valeurs initiales différentes de résistance Ron, on applique successivement plusieurs impulsions d'effacement (avec une valeur de tension constante) en augmentant le temps d'effacement à chaque impulsion. La durée d'impulsion à partir de laquelle la cellule mémoire est effacée (donc lorsque l'état faiblement résistif commute à l'état fortement résistif) est définie comme le temps d'effacement (Vreset). Le fait d'appliquer cette technique à plusieurs valeurs de résistance Ron initiales permet de construire la courbe représentative de la loi de dépendance Ld2, pour une valeur de tension donnée.

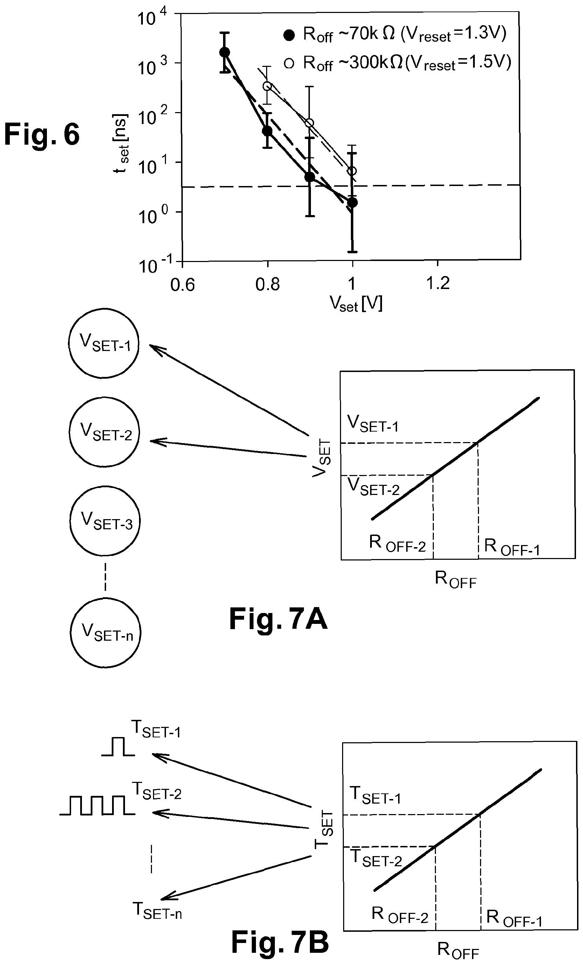

Dans d'autres modes de réalisation, la loi reliant la durée ou le nombre d'impulsions à la valeur de tension est connue et peut être représentée sous la forme d'une courbe telle que celle représentée sur la figure 6. Dans ces modes de réalisation, la durée ou le nombre d'impulsions sont déduits de la loi de dépendance reliant la valeur de tension à la valeur de résistance ou, inversement, la valeur de la tension de programmation est déduite de la loi de dépendance reliant la durée ou le nombre d'impulsions à la valeur de la résistance.

Quelle que soit la loi de dépendance choisie, le procédé selon l'invention comporte les étapes suivantes :
- lecture, à la fin d'une opération d'écriture ou d'effacement (n-1), de la valeur de résistance du matériau diélectrique ;
- comparaison de cette valeur de résistance lue à des valeurs de référence telle que les valeurs de résistance médianes, au moyen d'un des procédés décrits par la suite;
- détermination des conditions de programmation à partir du résultat de cette comparaison;
- application, à la cellule mémoire, des conditions de programmation déterminée pour l'opération d'effacement ou d'écriture suivante n.

Selon une première variante, la comparaison de la valeur de résistance lue à des valeurs de référence peut être réalisée par comparaison de ladite valeur de résistance lue avec plusieurs amplificateurs de détection (ou « sense amplifier », en termes anglo-saxons) de niveaux différents. Selon une deuxième variante, cette comparaison peut également être réalisée en comparant le niveau de courant dans la cellule mémoire à celui sorti par une rampe de courant relié à un compteur de sorte à détecter l'instant où les deux courants sont égaux. Cette deuxième variante, bien que plus lente que la première variante, permet une détermination plus précise de la valeur de résistance avec un unique comparateur.

Comme expliqué précédemment, la valeur de résistance Ron ou Roff lue à la fin d'une opération d'écriture ou d'effacement est mémorisée dans des cellules mémoires de la mémoire résistive. Selon certains modes de réalisation, la place mémoire dédiée à la mise en œuvre du procédé de l'invention peut être optimisée en ne mémorisant, par exemple, que les valeurs des cellules mémoires considérées comme les plus sensibles par l'utilisateur comme, par exemple, les cellules les plus souvent effacées et réécrites de la mémoire résistive et/ou les cellules mémoire utilisant les tensions de programmation les plus élevées.

En effet, le procédé de l'invention - avec adaptation des conditions d'écriture - peut n'être mis en œuvre que pour une fraction de la mémoire totale, ce qui correspond à un nombre réduit de cellules mémoire. Ce nombre réduit de cellules mémoire peut être choisi, par l'utilisateur, comme les cellules sensibles.

Selon certains modes de réalisation, une mémoire associative est utilisée pour stocker les adresses et conditions d'effacement : la partie « tag » de cette mémoire associative peut, par exemple, être réalisée en ReRAM car écrite peu souvent. Les conditions d'effacement sont codées en SRAM, technologie non-sujette à l'usure. Le procédé de l'invention n'est utilisé que sur une faible portion de la mémoire car la taille des mémoires SRAM est supérieure à celle des ReRAM.

Selon certains modes de réalisation, la place mémoire dédiée à la mise en œuvre du procédé de l'invention peut être optimisée en utilisant les zones de mémoire cache de la mémoire résistive pour stocker momentanément les valeurs des conditions d'effacement et les utiliser au moment où la mémoire cache doit être vidée pour y stocker une autre donnée. La mémoire cache est alors utilisée pour stocker successivement plusieurs données de types différents.

Selon certains modes de réalisation, la place mémoire dédiée au stockage des valeurs lues peut être optimisée en ne stockant qu'une tendance des conditions d'écriture et/ou d'effacement à appliquer, cette tendance pouvant être plus ou moins précise. Par exemple, pour diminuer le nombre de cellules mémoire nécessaires au stockage des valeurs lues, il est possible de coder, sur une seule cellule mémoire, les tendances « augmenter la tension d'écriture » et « diminuer la tension d'écriture ». En augmentant le nombre de cellules mémoire, la nuance de la tendance peut être affinée ; par exemple, en codant sur deux cellules mémoire, il est possible de coder les informations « appliquer la tension médiane + n% », « appliquer la tension médiane - n% », « appliquer la tension médiane + 2n% » et « appliquer la tension médiane - 2n% ».

L'homme du métier comprendra qu'un nombre élevé de cellules mémoire dédiées à la mise en œuvre du procédé de l'invention permet de coder des conditions de programmation affinées. Il comprendra, en outre, que plusieurs des modes de réalisation décrits précédemment peuvent être mis en œuvre simultanément afin d'optimiser au mieux le ratio entre la place mémoire dédiée à la mise en œuvre du procédé et la précision de la détermination des conditions de programmation.

Le procédé selon l'invention peut être mis en œuvre dans un dispositif de programmation d'une mémoire résistive. Ce dispositif peut comporter un circuit de programmation, connecté aux électrodes supérieure et inférieure de chaque cellule mémoire de la mémoire.

Selon certains modes de réalisation, le circuit de programmation comporte une pluralité de générateurs de tension aptes à délivrer chacun au moins une valeur de tension de programmation différente de la valeur de tension délivrée par les autres générateurs. En effet, pour appliquer les valeurs de tension de programmation déterminées par le procédé de l'invention, plusieurs générateurs de tension peuvent être nécessaires, comme représenté sur la figure 7A. Le circuit de programmation peut alors choisir, parmi les générateurs de tension, le nombre et la combinaison de ces générateurs qui permettent d'approcher au mieux la valeur de tension de programmation déterminée. Toutefois, afin de limiter le nombre de générateurs de tension, chaque générateur peut comporter des ponts diviseurs qui, par divisions d'une tension de référence, permettent d'appliquer aux électrodes la valeur de tension de programmation la plus proche de la valeur déterminée.

Selon certains autres modes de réalisation, le circuit de programmation comporte un seul (ou plusieurs) générateur(s) de tension délivrant (chacun) une valeur de tension constante. Ce générateur de tension est connecté à au moins un compteur et/ou une horloge aptes à contrôler la durée ou le nombre d'impulsions de tension constante à appliquer aux électrodes pour obtenir un résultat identique à celui qui aurait été obtenu avec une valeur de tension de programmation déterminée dans les modes de réalisation où la tension est variable. Un exemple d'application du nombre d'impulsions à une tension constante, déterminé avec le procédé selon l'invention, pour une opération d'écriture est représenté schématiquement sur la figure 7B.

Ainsi, le procédé selon l'invention permet de gérer l'endurance d'une mémoire résistive en déterminant, à chaque cycle, les conditions d'écriture et d'effacement de chaque cellule mémoire au cycle suivant. Le procédé selon l'invention permet ainsi d'améliorer l'endurance d'une mémoire résistive et, par conséquent, d'augmenter la durée de vie de ladite mémoire.

Bien que décrit à travers un certain nombre d'exemples, variantes et modes de réalisation, le procédé de gestion d'endurance selon l'invention et le dispositif de programmation mettant en œuvre ce procédé comprennent divers variantes, modifications et perfectionnements qui apparaîtront de façon évidente à l'homme du métier, étant entendu que ces variantes, modifications et perfectionnements font partie de la portée de l'invention.

## Revendications

1. Procédé de gestion de l'endurance d'une mémoire réinscriptible non-volatile comprenant une pluralité d'empilements (10) ordonnés d'une électrode inférieure (12), d'une couche de matériau diélectrique (13) et d'une électrode supérieure (11), le matériau diélectrique de chaque empilement étant apte à commuter entre :
- un état fortement résistif (HRS), dans lequel ledit matériau diélectrique (13) présente une première valeur de résistance (Roff), et
- un état faiblement résistif (LRS), dans lequel ledit matériau diélectrique (13) présente une deuxième valeur de résistance (Ron),
une commutation entre l'état fortement résistif et l'état faiblement résistif autorisant une écriture dans la mémoire et une commutation entre l'état faiblement résistif et l'état fortement résistif autorisant un effacement dans ladite mémoire,
**caractérisé en ce qu'**il comporte les opérations suivantes:
- à la fin de chaque opération d'effacement : une lecture de la première valeur de résistance (Roff) du matériau diélectrique, une comparaison de ladite première valeur de résistance avec une première valeur de résistance médiane (Roffmed) prédéterminée, et une détermination de conditions de programmation en écriture (Vset, Tset) à partir des résultats de ladite comparaison ; la première valeur de résistance médiane (Roffmed) suivant une première loi de dépendance (Ld1) prédéterminée reliant les conditions de programmation en écriture et la première valeur de résistance lue, la valeur des conditions de programmation en écriture étant déduite de ladite première loi de dépendance (Ld1) ; et
- à la fin de chaque opération d'écriture : une lecture de la deuxième valeur de résistance (Ron) du matériau, une comparaison de ladite deuxième valeur de résistance avec une deuxième valeur de résistance médiane (Ronmed) prédéterminée, et une détermination de conditions de programmation en effacement (Vreset, Treset) à partir des résultats de ladite comparaison, la deuxième valeur de résistance médiane (Ronmed) suivant une deuxième loi de dépendance (Ld2) prédéterminée reliant les conditions de programmation en effacement et la deuxième valeur de résistance lue, la valeur des conditions de programmation en effacement étant déduite de ladite deuxième loi de dépendance(Ld2) ;
lesdites conditions de programmation en écriture et en effacement étant appliquées aux électrodes (11, 12) de l'empilement lors, respectivement, d'opérations d'écriture et d'effacement suivantes afin de limiter la génération de défauts dans le matériau diélectrique (13).

2. Procédé selon la revendication 1, **caractérisé en ce que** les conditions de programmation comprennent une tension de programmation (Vset, Vreset) appliquée entre les électrodes de chaque empilement pendant une durée constante.

3. Procédé selon la revendication 1, **caractérisé en ce que** les conditions de programmation comprennent une durée d'application (Tset) d'une tension entre les électrodes de chaque empilement, ladite tension étant constante.

4. Procédé selon l'une quelconque des revendications 1 à 3, **caractérisé en ce que** chaque loi de dépendance (Ld1, Ld2) est calibrée préalablement à toutes opérations d'écriture et d'effacement.

5. Procédé selon l'une quelconque des revendications 1 à 4, **caractérisé en ce que** les conditions de programmation lues sont mémorisées au moins partiellement jusqu'aux opérations d'écriture ou d'effacement suivantes, dans au moins une cellule mémoire de la mémoire.

6. Dispositif de programmation d'une mémoire réinscriptible non-volatile comportant un circuit de programmation (15) connecté aux électrodes de chaque empilement de la mémoire, **caractérisé en ce qu'**il met en œuvre le procédé selon l'une quelconque des revendications 1 à 5.

7. Dispositif selon la revendication 6, **caractérisé en ce que** le circuit de programmation (15) comporte une pluralité de générateurs de tension aptes à générer chacun au moins une valeur de tension de programmation.

8. Dispositif selon la revendication 6 ou 7, **caractérisé en ce que** le circuit de programmation (15) comporte au moins un générateur de tension connecté à des ponts diviseurs.

9. Dispositif selon la revendication 6 ou 7, **caractérisé en ce que** le circuit de programmation (15) comporte au moins un générateur de tension connecté à au moins un compteur et/ou une horloge apte à moduler une durée d'application d'une tension constante sur les électrodes.

## Patentansprüche

1. Verfahren zur Steuerung der Lebensdauer eines nicht-flüchtigen überschreibbaren Speichers, umfassend eine Vielzahl geordneter Stapel (10) aus einer unteren Elektrode (12), einer Schicht aus dielektrischem Material (13) und einer oberen Elektrode (11), wobei das dielektrische Material jedes Stapels imstande ist, umzuschalten zwischen:
- einem stark resistiven Zustand (HRS), in dem das dielektrische Material (13) einen ersten Widerstandswert (Roff) aufweist, und
- einem schwach resistiven Zustand (LRS), in dem das dielektrische Material (13) einen zweiten Widerstandswert (Ron) aufweist,
wobei eine Umschaltung zwischen dem stark resistiven Zustand und dem schwach resistiven Zustand ein Schreiben in dem Speicher erlaubt und eine Umschaltung zwischen dem schwach resistiven Zustand und dem stark resistiven Zustand ein Löschen in dem Speicher erlaubt,
**dadurch gekennzeichnet, dass** es die folgenden Vorgänge aufweist:
- am Ende jedes Löschvorgangs: ein Lesen des ersten Widerstandswerts (Roff) des dielektrischen Materials, ein Vergleichen des ersten Widerstandswerts mit einem vorbestimmten mittleren ersten Widerstandswert (Roffmed) und ein Bestimmen von Schreibprogrammierbedingungen (Vset, Tset) auf der Basis der Ergebnisse des Vergleichs, wobei der erste mittlere Widerstandswert (Roffmed) gemäß einem vorbestimmten ersten Abhängigkeitsgesetz (Ld1) die Schreibprogrammierbedingungen und den gelesenen ersten Widerstandswert verbindet, wobei der Wert der Schreibprogrammierbedingungen vom ersten Abhängigkeitsgesetz (Ld1) abgeleitet ist, und
- am Ende jedes Schreibvorgangs: ein Lesen des zweiten Widerstandswerts (Ron) des Materials, ein Vergleichen des zweiten Widerstandswerts mit einem vorbestimmten mittleren zweiten Widerstandswert (Ronmed) und ein Bestimmen von Löschprogrammierbedingungen (Vreset, Treset) auf der Basis der Ergebnisse des Vergleichs, wobei der zweite mittlere Widerstandswert (Ronmed) gemäß einem vorbestimmten zweiten Abhängigkeitsgesetz (Ld2) die Löschprogrammierbedingungen und den gelesenen zweiten Widerstandswert verbindet, wobei der Wert der Löschprogrammierbedingungen vom zweiten Abhängigkeitsgesetz (Ld2) abgeleitet ist,
wobei die Schreib- und Löschprogrammierbedingungen auf die Elektroden (11, 12) des Stapels bei jeweils folgenden Schreib- und Löschvorgängen angewendet werden, um die Erzeugung von Fehlern im dielektrischen Material (13) zu begrenzen.

2. Verfahren nach Anspruch 1, **dadurch gekennzeichnet, dass** die Programmierbedingungen eine Programmierspannung (Vset, Vreset) umfassen, die zwischen den Elektroden jedes Stapels während einer konstanten Dauer angewendet wird.

3. Verfahren nach Anspruch 1, **dadurch gekennzeichnet, dass** die Programmierbedingungen eine Anwendungsdauer (Tset) einer Spannung zwischen den Elektroden jedes Stapels umfassen, wobei die Spannung konstant ist.

4. Verfahren nach einem der Ansprüche 1 bis 3, **dadurch gekennzeichnet, dass** jedes Abhängigkeitsgesetz (Ld1, Ld2) zuvor auf alle Schreib- und Löschvorgänge kalibriert wird.

5. Verfahren nach einem der Ansprüche 1 bis 4, **dadurch gekennzeichnet, dass** die gelesenen Programmierbedingungen mindestens zum Teil bis zu den folgenden Schreib- oder Löschvorgängen in mindestens einer Speicherzelle des Speichers gespeichert werden.

6. Programmiervorrichtung eines nicht-flüchtigen überschreibbaren Speichers, umfassend eine Programmierschaltung (15), die an die Elektroden jedes Stapels des Speichers angeschlossen ist, **dadurch gekennzeichnet, dass** sie das Verfahren nach einem der Ansprüche 1 bis 5 durchführt.

7. Vorrichtung nach Anspruch 6, **dadurch gekennzeichnet, dass** die Programmierschaltung (15) eine Vielzahl von Spannungserzeugern aufweist, die imstande sind, jeweils mindestens einen Programmierspannungswert zu erzeugen.

8. Vorrichtung nach Anspruch 6 oder 7, **dadurch gekennzeichnet, dass** die Programmierschaltung (15) mindestens einen Spannungserzeuger aufweist, der an Teilerbrücken angeschlossen ist.

9. Vorrichtung nach Anspruch 6 oder 7, **dadurch gekennzeichnet, dass** die Programmierschaltung (15) mindestens einen Spannungserzeuger aufweist, der an mindestens einen Zähler und/oder eine Uhr angeschlossen ist, die imstande sind, die Anwendungsdauer einer konstanten Spannung auf die Elektroden zu modulieren.

## Claims

1. Method for managing the endurance of a non-volatile rewritable memory including a plurality of ordered stacks (10) of a lower electrode (12), a layer of dielectric material (13) and an upper electrode (11), the dielectric material of each stack being capable of switching between:
- a high resistance state (HRS), in which said dielectric material (13) has a first resistance value (Roff), and
- a low resistance state (LRS), in which said dielectric material (13) has a second resistance value (Ron),
a switching between the high resistance state and the low resistance state allowing a writing in the memory and a switching between the low resistance state and the high resistance state allowing an erasure in said memory,
**characterised in that** it comprises at least one of the following operations:
- at the end of each erasure operation: reading the first resistance value (Roff) of the dielectric material, comparing said first resistance value with a first predetermined median resistance value (Roffmed), and determining the writing programming conditions (Vset, Tset) from the results of said comparison; the first predetermined median resistance value (Roffmed) following a first predetermined dependency law (Ld1) linking the writing programming conditions and the first read resistance value, the value of the writing programming conditions being deduced from said first predetermined dependency law (Ld1); and
- at the end of each writing operation: reading the second resistance value (Ron) of the material, comparing said second resistance value with a second predetermined median resistance value (Ronmed), and determining the erasure programming conditions (Vreset, Treset) from the results of said comparison, the second median resistance value (Ronmed) following a second predetermined dependency law (Ld2) linking the erasure programming conditions and the second read resistance value, the value of the erasure programming conditions being deduced from said second predetermined dependency law (Ld2);
said writing and erasure programming conditions being applied to the electrodes (11, 12) of the stack during, respectively, following writing and erasure operations in order to limit the generation of defects in the dielectric material (13).

2. Method according to claim 1, **characterised in that** the programming conditions include a programming voltage (Vset, Vreset) applied between the electrodes of each stack for a constant duration.

3. Method according to claim 1, **characterised in that** the programming conditions include a duration of application (Tset) of a voltage between the electrodes of each stack, said voltage being constant.

4. Method according to any of claims 1 to 3, **characterised in that** each dependency law (Ld1, Ld2) is calibrated prior to all writing and erasure operations.

5. Method according to any of claims 1 to 4, **characterised in that** the read programming conditions are memorised at least partially up to the following writing or erasure operations, in at least one memory cell of the memory.

6. Device for programming a non-volatile rewritable memory comprising a programming circuit (15) connected to the electrodes of each stack of the memory, **characterised in that** it implements the method according to any of claims 1 to 5.

7. Device according to claim 6, **characterised in that** the programming circuit (15) comprises a plurality of voltage generators each capable of generating at least one programming voltage value.

8. Device according to claim 6 or 7, **characterised in that** the programming circuit (15) comprises at least one voltage generator connected to dividing bridges.

9. Device according to claim 6 or 7, **characterised in that** the programming circuit (15) comprises at least one voltage generator connected to at least one counter and/or one clock capable of modulating a duration of application of a constant voltage to the electrodes.
